(19) Europäisches Patentamt
European Patent Office
Office européen des brevets

(11) EP 4 730 432 A1

(12) EUROPEAN PATENT APPLICATION
published in accordance with Art. 153(4) EPC

(43) Date of publication:
22.04.2026 Bulletin 2026/17

(51) International Patent Classification (IPC):
H01M 4/505 (2010.01)

(21) Application number: 24939412.3

(22) Date of filing: 22.10.2024

(52) Cooperative Patent Classification (CPC):
Y02E 60/10

(86) International application number:
PCT/CN2024/126545

(87) International publication number:
WO 2025/241398 (27.11.2025 Gazette 2025/48)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 24.05.2024 CN 202410651224

(71) Applicants:
• Guangdong Brunp Recycling Technology Co., Ltd.
Foshan, Guangdong 528137 (CN)
• Hunan Brunp Recycling Technology Co., Ltd.
Changsha, Hunan 410600 (CN)

(72) Inventors:
• YU, Haijun
Foshan, Guangdong 528137 (CN)
• LI, Changdong
Foshan, Guangdong 528137 (CN)
• WANG, Tao
Foshan, Guangdong 528137 (CN)
• HUANG, Weiyan
Foshan, Guangdong 528137 (CN)

(74) Representative: Westphal, Mussgnug & Partner,
Patentanwälte mbB
Werinherstraße 79
81541 München (DE)

(54) **SINGLE-CRYSTAL TERNARY POSITIVE ELECTRODE MATERIAL, PREPARATION METHOD THEREFOR, POSITIVE ELECTRODE SHEET, AND BATTERY**

(57) The present application discloses a single-crystal ternary cathode material, a preparation method therefor, a cathode electrode plate, and a battery, and belongs to the technical field of battery materials. The single-crystal ternary cathode material has an apparent factor

$$Z = \frac{\left(\frac{1}{S(D_{90})}\right)^x \times H}{1.2 - 19.4 \times 0.18^x} \quad , \quad \text{with} \quad 1.1 \leq Z \leq 3;$$

$x = D_{90}/D_{10}$, $2 \leq x \leq 5$; wherein $S(D_{90})$ is a number-average circularity equal to a sum of circularities of all target particles divided by n, n is a total number of the target particles; an area and a perimeter corresponding to a two-dimensional projected image of an individual target particle are $S_i$ and $l_1$ respectively, a circle with the area $S_1$ has a perimeter of $l_2$ and a circularity = $l_2/l_1$;

$$H = \frac{D_{10}'}{D_{10}} \times 100\% \quad ,$$ $D_{10}'$ is a particle size of a material obtained by pressing the single-crystal ternary cathode material under a pressure of 200 MPa, $D_{10}$ does not exceed 2.4 $\mu$m, and $D_{10}'$ does not exceed 2.3 $\mu$m. The single-crystal ternary cathode material has a smooth surface and rounded corners, and is conducive to the preparation of a battery with excellent electrochemical performance.

FIG.1

**Description**

**CROSS-REFERENCE TO RELATED APPLICATION**

The present application claims priority to Chinese Patent Application No. 202410651224.2 filed with the China National Intellectual Property Administration on 24 May 2024 and titled "SINGLE-CRYSTAL TERNARY CATHODE MATERIAL, PREPARATION METHOD THEREFOR, CATHODE ELECTRODE SHEET, AND BATTERY", the entire contents of which are incorporated herein by reference.

**TECHNICAL FIELD**

The present disclosure relates to the technical field of battery materials, and in particular to a single-crystal ternary cathode material, a preparation method therefor, a cathode electrode sheet, and a battery.

**BACKGROUND**

At present, a ternary cathode material is typically composed of polycrystalline secondary particles formed by agglomeration of nanoscale primary particles. During a charge-discharge cycling, unit cell volume of the primary particles changes, leading to anisotropically distributed stress in the secondary particles, further resulting in intergranular cracks in the polycrystalline secondary particles, and may even result in the polycrystalline particle fragmentation. On the other hand, the preparation of an electrode sheet of the cathode material involves rolling, so that the agglomerated polycrystalline secondary particles are easily crushed, thereby affecting the cycle life of a battery, and restricting commercial applications thereof.

In contrast, a single-crystal ternary cathode material is composed of individual micron-sized particles. Therefore, its mechanical strength is high, it is less prone to be crushed during rolling of the electrode sheet, does not generate intergranular cracks during the charge-discharge cycling, has more excellent cycling stability, and is a high-performance cathode material expected to partially replace the polycrystalline ternary cathode material.

Conventionally, the single-crystal material is prepared by mixing hydroxide precursor secondary particles with a lithium source, followed by high-temperature sintering and subsequent airflow pulverization. However, the above process will forcefully deagglomerate the agglomerated particles, thereby resulting in sharp corners. Such sharp corners may cause at least one of the following problems.

(1) During battery electrode preparation, the sharp corners cause severe abrasion to an apparatus, shorten service life of parts of the apparatus, and greatly increase manufacturing costs of the battery.

(2) During rolling for preparation of the electrode sheet, particles with sharp corners are more likely to be crushed, thereby resulting in single-crystal delamination and surface defects, and forming more fine particles.

(3) The sharp corners will cause non-uniform degree of charge and discharge of the material, leading to severe polarization, and may even cause particle fragmentation due to stress during the cycle, resulting in rapid attenuation of the battery life.

(4) During surface coating of the single-crystal material, the sharp corners can hardly be completely coated, thereby affecting the coating effect, which prevents any improvement in the cycling performance.

In view of the above, the present disclosure is presented.

**SUMMARY**

An objective of the present disclosure includes providing a single-crystal ternary cathode material, a preparation method therefor, a cathode electrode sheet, and a battery, so as to solve or improve at least one of the above technical problems.

The present disclosure can be implemented as follows.

In a first aspect, the present disclosure provides a single-crystal ternary cathode material, having an apparent factor $Z = \dfrac{\left(\frac{1}{S(D_{90})}\right)^{x} \times H}{1.2 - 19.4 \times 0.18^{x}}$, with Z = 1.1 to 3.0;

where $x = D_{90}/D_{10}$, $2 \leq x \leq 5$; $D_{90}$ is a particle size of the single-crystal ternary cathode material when volume-based cumulative particle size distribution of the single-crystal ternary cathode material reaches 90%, $D_{10}$ is a particle size of the single-crystal ternary cathode material when the volume-based cumulative particle size distribution of the single-crystal ternary cathode material reaches 10%; $D_{10}$ of the single-crystal ternary cathode material does not exceed 2.4 $\mu$m;

$S(D_{90})$ is a number-average circularity equal to a sum of circularities of all target particles contained in the single-crystal ternary cathode material divided by n; the circularity $Q=l_2/l_1$, wherein an area and a perimeter corresponding to a two-dimensional projected image of an individual target particle are defined as Si and $l_1$ respectively, a perimeter of a circle with the area Si is defined as $l_2$, the target particle is defined as a single-crystal ternary cathode material particle with a particle size greater than or equal to $D_{90}$ in the single-crystal ternary cathode material, and n is a total number of the target particles contained in the single-crystal ternary cathode material; and

H is hardness, $H = \dfrac{D_{10}{}'}{D_{10}} \times 100\%$ , wherein $D_{10}'$ is a particle size when volume-based cumulative particle size distribution of a pressed material reaches 10%, the pressed material is a material obtained by pressing the single-crystal ternary cathode material under a pressure of 200 MPa; and the $D_{10}'$ of the single-crystal ternary cathode material does not exceed 2.3 $\mu$m.

In an optional embodiment, the single-crystal ternary cathode material includes at least one of the features below:

feature I: the $D_{90}$ of the single-crystal ternary cathode material does not exceed 8.6 $\mu$m;
feature II: the H of the single-crystal ternary cathode material is not less than 80%; and
feature III: the $S(D_{90})$ of the single-crystal ternary cathode material does not exceed 0.9.

In an optional embodiment, the apparent factor of the single-crystal ternary cathode material is 1.1634 to 2.9571; and/or,

the x of the single-crystal ternary cathode material is 2.36 to 3.88; and/or,
the $D_{90}$ of the single-crystal ternary cathode material is 5.01 $\mu$m to 8.56 $\mu$m; and/or,
the $D_{10}$ of the single-crystal ternary cathode material is 1.81 $\mu$m to 2.34 $\mu$m; and/or,
the H of the single-crystal ternary cathode material is 81% to 96%; and/or,
the $S(D_{90})$ of the single-crystal ternary cathode material is 0.68 to 0.87; and/or,
the $D_{10}'$ of the single-crystal ternary cathode material is 1.57 $\mu$m to 2.25 $\mu$m.

In an optional embodiment, the single-crystal ternary cathode material further includes at least one of the features below:

feature IV: the single-crystal ternary cathode material has a particle size of no more than 20 $\mu$m;

feature V: the single-crystal ternary cathode material has a general formula of $Li_dNi_aCo_bM_cM'_{1-a-b-c}O_2$, where $0.95 \leq d < 1.1$, a>0, b>0, c>0, $0.95 \leq (a+b+c) \leq 1$; M includes at least one of Al and Mn, M' includes at least one of a doping element and a coating element, and the doping element and the coating element are each independently at least one of Zr, Sr, Mo, Ba, W, B, Ti, Mg, Li, C, F, Si, Ca, Cu, La, P, Ce, Bi, In, Nb, and Y;

feature VI: in the single-crystal ternary cathode material, a unit cell parameter c and a unit cell parameter a satisfy $c/a \geq 4.899$;

feature VII: a (003) crystal plane diffraction peak intensity $I_{(003)}$ and a (104) crystal plane diffraction peak intensity $I_{(104)}$ of the single-crystal ternary cathode material satisfy: $I_{(003)}/I_{(104)} \geq 1.51$; and

feature VIII: a surface roughness Ra of an electrode sheet comprising the single-crystal ternary cathode material does not exceed 2.20 $\mu$m.

In an optional embodiment, a doping reagent providing the doping element includes at least one of an oxide, a fluoride, a carbonate, a hydroxide, a nitride, a boride, and a nitrate comprising a corresponding doping element; and/or, a coating reagent providing the coating element includes at least one of an oxide, a fluoride, a carbonate, a hydroxide, a nitride, a boride, and a nitrate comprising a corresponding coating element.

In an optional embodiment, the surface roughness Ra of the electrode sheet comprising the single-crystal ternary cathode material is 0.86 $\mu$m to 2.12 $\mu$m.

In a second aspect, the present disclosure provides a method for preparing a single-crystal ternary cathode material according to any one of the above embodiments, including the following step:

mixing a precursor of the single-crystal ternary cathode material with a first lithium source, and then performing a first calcination to obtain a first mixture;

immediately transferring the first mixture at a high temperature into water and performing a first crushing under stirring to obtain a second mixture;

mixing the second mixture with a second lithium source and then performing a second calcination to obtain a third mixture; and

performing a second crushing on the third mixture to obtain a fourth mixture.

In an optional embodiment, the preparation of the first mixture includes at least one of the features below:

feature 1: the precursor of the single-crystal ternary cathode material is a hydroxide precursor;

feature 2: a ratio of a total mole number of a transition metal element in the precursor of the single-crystal ternary cathode material to a mole number of lithium element in the first lithium source ranges from 1: 0.4 to 1: 0.7;

feature 3: the first calcination is performed at a temperature of 650°C to 750°C;

feature 4: the first calcination is performed for 1 h to 3 h; and

feature 5: the first calcination is performed in an oxygen-containing atmosphere.

In an optional embodiment, the precursor of the single-crystal ternary cathode material includes a nickel-cobalt-manganese hydroxide or a nickel-cobalt-aluminum hydroxide.

In an optional embodiment, the first crushing includes at least one of the features below:

feature 6: the first crushing is implemented based on a thermal expansion and contraction effect;
feature 7: the water used for the first crushing has a temperature greater than 0°C and no more than 50°C;
feature 8: the first crushing is performed at a stirring speed of 100 rpm to 200 rpm;
feature 9: the first crushing is performed under stirring for 5 min to 20 min; and/or,
the second crushing is performed by airflow crushing.

In an optional embodiment, the first mixture at a high temperature is transferred into the water within 30 min.
In an optional embodiment, the preparation of the third mixture includes at least one of the features below:

feature 10: a ratio of a total mole number of lithium element in the first lithium source and the second lithium source to a total mole number of a transition metal element in the second mixture ranges from 1.05: 1 to 1.1: 1;
feature 11: the second calcination is performed at a temperature of 800°C to 950°C;
feature 12: the second calcination is performed for 4 h to 6 h; and
feature 13: the second calcination is performed in an oxygen-containing atmosphere.

In an optional embodiment, when the single-crystal ternary cathode material contains a doping element, the precursor of the single-crystal ternary cathode material and the first lithium source are mixed with the doping reagent for providing the doping element and then the first calcination is performed; or the second mixture and the second lithium source are mixed with the doping reagent for providing the doping element and then the second calcination is performed; or,
when the single-crystal ternary cathode material contains a coating element, the preparation method further includes: mixing the fourth mixture with the coating reagent for providing the coating element and then performing a third calcination.
In an optional embodiment, the first calcination is performed in the oxygen-containing atmosphere with an oxygen content ≥20wt%; and/or the second calcination is performed in the oxygen-containing atmosphere with an oxygen content ≥20wt%; and/or the third calcination is performed in an oxygen-containing atmosphere with an oxygen content ≥20wt%.
In a third aspect, the present disclosure provides a cathode electrode sheet, where an active material of the cathode electrode sheet includes the single-crystal ternary cathode material according to any of the above embodiments.

In an optional embodiment, the cathode electrode sheet has at least one of the features below:

feature IX: the cathode electrode sheet has an initial discharge specific capacity at 0.1C of no less than 171.0 mAh/g;

feature X: the cathode electrode sheet has a capacity retention ratio at 0.1C after 50 cycles of no less than 89.2%;

feature XI: the cathode electrode sheet has an initial discharge specific capacity at 1C of no less than 148.3 mAh/g; and

feature XII: the cathode electrode sheet has an initial discharge specific capacity at 5C of no less than 125.8 mAh/g.

In a fourth aspect, the present disclosure provides a battery cell, including the cathode electrode sheet according to the above embodiments.

In a fifth aspect, the present disclosure provides a battery, including the battery cell according to the above embodiments.

In a sixth aspect, the present disclosure provides an electrical device, including the battery cell or the battery according to the above embodiments.

In an optional embodiment, the electrical device includes a mobile phone, a tablet computer, a notebook computer, an electric toy, an electric tool, an electric bicycle, an electric vehicle, a ship, or a spacecraft.

The beneficial effects of the present disclosure are as follows.

The present disclosure presents a single-crystal ternary cathode material with an apparent factor within a particular range. The single-crystal ternary cathode material features a smooth surface and rounded corners, so that an electrode using it as a cathode material has high specific capacity, superior rate performance, and excellent cycling performance. Correspondingly, the preparation method of the single-crystal ternary cathode material is simple and easy to operate, and suitable for industrial-scale production. Furthermore, the single-crystal ternary cathode material can be used to prepare batteries and electrical devices with excellent electrochemical performance.

**BRIEF DESCRIPTION OF THE DRAWINGS**

To more clearly describe technical solutions of examples of the present disclosure, drawings in the examples will be briefly introduced below, and it should be understood that the following drawings only show some examples of the present disclosure, and therefore should not be construed as limiting the scope of the present disclosure. For those having ordinary skills in the art, other relevant drawings may also be obtained based on these drawings without creative work.

FIG. 1 shows XRD patterns of single-crystal ternary cathode materials obtained from Examples 1-5 and Comparative Example 1;

FIG. 2 shows scanning electron microscope (SEM) images of single-crystal ternary cathode materials obtained from Examples 1 and 10 and Comparative Example 1; and

FIG. 3 shows relationships between apparent factors of the single-crystal ternary cathode materials obtained from Examples 1-13 and Comparative Examples 1-4 and surface roughnesses of electrode sheets comprising the single-crystal ternary cathode materials.

**DETAILED DESCRIPTION**

To make objectives, technical solutions, and advantages of examples of the present disclosure clearer, the technical solutions in the examples of the present disclosure will be clearly and completely described below. The examples without clear indication of specific conditions are carried out based on conventional conditions or based on conditions recommended by manufacturers. Where no manufacturers are specified, the reagents or instruments used are all commercially available conventional products.

A single-crystal ternary cathode material, a preparation method therefor, a cathode electrode sheet, and a battery provided in the present disclosure are detailed below.

The present disclosure presents a single-crystal ternary cathode material, having an apparent factor

$$Z = \frac{\left(\frac{1}{S(D_{90})}\right)^x \times H}{1.2 - 19.4 \times 0.18^x}$$ , with Z = 1.1 to 3.0.

The present disclosure presents a single-crystal ternary cathode material with an apparent factor within a particular range. The single-crystal ternary cathode material features a smooth surface and rounded corners, so that an electrode and a battery using it as a cathode material have high specific capacity, superior rate performance, and excellent cycling performance.

The apparent factor combines a plurality of apparent indicators (such as particle size distribution, particle shape, and hardness) of the single-crystal ternary cathode material. The apparent indicators are related to a compaction density of the single-crystal ternary cathode material, and the compaction density of the single-crystal ternary cathode material is closely related to surface roughness and electrochemical performance of the electrode sheet containing the single-crystal ternary cathode material. Generally, the greater the compaction density of the cathode material, the better the electrochemical performance of the corresponding electrode. In addition, the surface roughness of the electrode sheet is a factor affecting the electrode performance. A smaller the surface roughness leads to superior cycling performance. Consequently, the apparent factor can be utilized to predict some properties of the cathode material and the electrode. For example, there is a cathode linear correlation between the apparent factor defined in the present disclosure and the surface roughness of the electrode sheet containing the single-crystal ternary cathode material.

The apparent factor of the above single-crystal ternary cathode material is 1.1 to 3.0. In some optional embodiments, the apparent factor of the single-crystal ternary cathode material may be, for example, 1.1634 to 2.9571, such as 1.1634, 1.1959, 1.3481, 1.5992, 1.6826, 1.7659, 1.7735, 1.7978, 1.9834, 2.1570, 2.2532, 2.5193, 2.8008, or 2.9571. A single-crystal ternary cathode material with an apparent factor within the above range can enable a battery using it as a cathode material to have better overall performance (including specific capacity, rate performance, cycling performance, etc.).

$x=D_{90}/D_{10}$, $2 \leq x \leq 5$, that is, x may be any value in the range of 2 to 5, for example, it may be 2, 2.5, 3, 3.5, 4, 4.5, or 5. In some optional embodiments, the $D_{90}/D_{10}$ value of the single-crystal ternary cathode material is 2.36 to 3.88, for example, it may be 2.36, 3.22, 3.35, 3.55, 3.67, or 3.88.

$D_{90}$ is a particle size of the single-crystal ternary cathode material when volume-based cumulative particle size distribution of the single-crystal ternary cathode material reaches 90%, and $D_{10}$ is a particle size of the single-crystal ternary cathode material when the volume-based cumulative particle size distribution of the single-crystal ternary cathode material reaches 10%.

In some optional embodiments, the $D_{90}$ of the single-crystal ternary cathode material does not exceed 8.6 $\mu$m, and may be, for example, 5.01 $\mu$m to 8.56 $\mu$m, such as 5.01 $\mu$m, 5.92 $\mu$m, 6.09 $\mu$m, 6.59 $\mu$m, 6.82 $\mu$m, 7.39 $\mu$m, 7.89 $\mu$m, or 8.56 $\mu$m.

In some optional embodiments, the $D_{10}$ of the single-crystal ternary cathode material does not exceed 2.4 $\mu$m, and may be, for example, 1.81 $\mu$m to 2.34 $\mu$m, such as 1.81, 1.84, 1.92, 1.96, 2.02, 2.11, 2.15, or 2.34.

$S(D_{90})$ is a number-average circularity, wherein a target particle is defined as a single-crystal ternary cathode material particle with a particle size greater than or equal to $D_{90}$ in the single-crystal ternary cathode material, and n is a total number of the target particles contained in the single-crystal ternary cathode material, and the number-average circularity is equal to a sum of circularities of all target particles contained in the single-crystal ternary cathode material divided by n.

An area and a perimeter corresponding to a two-dimensional projected image of an individual target particle are defined as $S_1$ and $l_1$ respectively, a perimeter of a circle with the area Si is defined as $l_2$, and the circularity $Q=l_2/l_1$.

In some optional embodiments, the $S(D_{90})$ of the single-crystal ternary cathode material does not exceed 0.9, and may be, for example, 0.68 to 0.87, such as 0.68, 0.70, 0.71, 0.73, 0.77, 0.79, 0.80, 0.82, 0.84, or 0.87.

Based on graded packing effects and various contact modes of irregularly shaped powders (such as co-occurrence of point-line-surface contacts), the single-crystal ternary cathode material with the above ranges of $D_{90}$, $D_{10}$, and $S(D_{90})$ is conducive to increasing the compaction density of the electrode containing the single-crystal ternary cathode material, reducing the surface roughness of the electrode sheet, and improving the electrochemical performance of the electrode and the corresponding battery. The $D_{90}/D_{10}$ can reflect particle size distribution width of powder. The powders with the above ranges of $D_{90}$ and the $D_{10}$ have the graded packing effects, which can increase the compaction density. Powders within the above $S(D_{90})$ range have irregular shapes, and therefore exhibit various contact modes (such as co-occurrence of point-line-surface contacts), which is conducive to increasing the contact between powders, thus further increasing the compaction density. A higher compaction density, in turn, contributes to superior electrochemical performance of the electrode sheet.

$H$ is hardness, $H = \dfrac{D_{10}{}'}{D_{10}} \times 100\%$, wherein $D_{10}'$ is a particle size when volume-based cumulative particle size distribution of a pressed material reaches 10%, and the pressed material is a material obtained by pressing the single-crystal ternary cathode material under a pressure of 200 MPa.

In some optional embodiments, the $D_{10}'$ of the single-crystal ternary cathode material does not exceed 2.3 $\mu$m, and may be, for example, 1.57 $\mu$m to 2.25 $\mu$m, such as 1.57 $\mu$m, 1.69 $\mu$m, 1.72 $\mu$m, 1.74 $\mu$m, 1.77 $\mu$m, 1.82 $\mu$m, 1.92 $\mu$m, or

2.25 μm.

In some optional embodiments, the H of the single-crystal ternary cathode material is not less than 80%, and may be, for example, 81% to 96%, such as 81%, 87%, 88%, 89%, 90%, 91%, 92%, or 96%.

In some optional embodiments, the particle size of the single-crystal ternary cathode material does not exceed 20 μm, which may also be understood as the particle size of a largest particle in the single-crystal ternary cathode material being less than or equal to 20 μm.

In some optional embodiments, the single-crystal ternary cathode material has a general formula of $Li_dNi_aCo_bM_cM'_{1-a-b-c}O_2$, where $0.95 \leq d < 1.1$, $a>0$, $b>0$, $c>0$, and $0.95 \leq (a+b+c) \leq 1$. The above a, b, c, and d are all expressed in mole number (mol).

M includes at least one of Al and Mn, that is, M may merely be Al, or M may merely be Mn, or M may include both Al and Mn.

M' includes at least one of a doping element and a coating element, that is, M' may merely be the doping element, M' may merely be the coating element, or M' may contain both the doping element and the coating element. When a+b+c=1, the single-crystal ternary cathode material contains neither a doping element nor a coating element.

As an example, the doping element and the coating element are each independently at least one of Zr, Sr, Mo, Ba, W, B, Ti, Mg, Li, C, F, Si, Ca, Cu, La, P, Ce, Bi, In, Nb, and Y. In some optional embodiments, the doping element and the coating element may be identical, and in some other optional embodiments, the doping element and the coating element may be different.

As an example, a doping reagent providing the doping element may include at least one of an oxide, a fluoride, a carbonate, a hydroxide, a nitride, a boride, and a nitrate comprising a corresponding doping element. Likewise, a coating reagent providing the coating element may also include at least one of an oxide, a fluoride, a carbonate, a hydroxide, a nitride, a boride, and a nitrate comprising a corresponding coating element.

In some optional embodiments, in the single-crystal ternary cathode material, a unit cell parameter c and a unit cell parameter a satisfy $c/a \geq 4.899$, and it may be, for example, 4.9174, 4.9234, 4.9375, 4.9425 or 4.9487. The single-crystal ternary cathode material with the above c/a value exhibits good crystallinity, a highly-ordered layered structure, and relatively stable crystal structure. Within the above range, the greater the c/a value, the more excellent the layer structure of the material, and the more conducive it is for the interlayer deintercalation of lithium ions.

In some optional embodiments, a (003) crystal plane diffraction peak intensity $I_{(003)}$ and a (104) crystal plane diffraction peak intensity $I_{(104)}$ of the single-crystal ternary cathode material satisfy: $R=I_{(003)}/I_{(104)} \geq 1.51$, and it may be, for example, 1.51, 1.62, 1.68, 1.74, or 1.87. The R value can be used to evaluate the degree of Li/Ni cation mixing. The greater the R value, the lower the degree of cation mixing in the material, and the more conducive its crystal structure for the intercalation and deintercalation of lithium ions.

In some optional embodiments, the surface roughness Ra of the single-crystal ternary cathode material does not exceed 2.20 μm, and it may be, for example, 0.86 μm to 2.12 μm, such as 0.86 μm, 1.17 μm, 1.20 μm, 1.23 ptm, 1.24 μm, 1.52 ttm, 1.61 μm, 1.62 μm, 1.67 μm, 1.75 μm, 1.76 μm, 1.84 μm, or 2.12 μm. The apparent factor presented in the present disclosure is linearly correlated with the surface roughness of the electrode sheet. The single-crystal ternary cathode material corresponding to the electrode with the above surface roughness exhibit a neat and smooth shape substantially without sharp corners.

Accordingly, the present disclosure further provides a method for preparing the above single-crystal ternary cathode material, which may include, for example, the following steps:

step (1): mixing a precursor of the single-crystal ternary cathode material with a first lithium source, and then performing a first calcination to obtain a first mixture;

step (2): performing a first crushing on the first mixture in water to obtain a second mixture;

step (3): mixing the second mixture with a second lithium source and then performing a second calcination to obtain a third mixture; and

step (4): performing a second crushing on the third mixture to obtain a fourth mixture.

In some optional embodiments, the precursor of the single-crystal ternary cathode material is a hydroxide precursor, which may be, for example, a nickel-cobalt-manganese hydroxide or a nickel-cobalt-aluminum hydroxide.

A ratio of a total mole number of a transition metal element in the precursor of the single-crystal ternary cathode material to a mole number of lithium element in the first lithium source may range from 1:0.4 to 1:0.7, such as 1:0.4, 1:0.45, 1:0.5, 1:0.55, 1:0.6, 1:0.65 or 1:0.7, or any other value within the range of 1:0.4 to 1:0.7.

The first calcination may be performed at a temperature of 650°C to 750°C, such as 650°C, 660°C, 670°C, 680°C, 690°C, 700°C, 710°C, 720°C, 730°C, 740°C, or 750°C, or any other value within the range of 650°C to 750°C.

If the first calcination is performed at a too low temperature, the material may fail to crystallize; and if the first calcination is performed at a too high temperature, it tends to cause severe Li/Ni cation mixing.

The first calcination may be performed for 1 h to 3 h, such as 1 h, 1.5 h, 2 h, 2.5 h, or 3 h, or any other value within the range of 1 h to 3 h.

The first calcination may be performed in an oxygen-containing atmosphere. As an example, oxygen content in the oxygen-containing atmosphere may be $\geq$20wt%. For example, the oxygen content in the oxygen-containing atmosphere may be, 20wt%, 30wt%, 40wt%, 50wt%, 60wt%, 70wt%, 80wt%, 90wt%, or 100wt%. In some optional embodiments, the oxygen content in the oxygen-containing atmosphere is $\geq$80wt%.

During the preparation of the single-crystal ternary cathode material, the first crushing is implemented based on a thermal expansion and contraction effect. As an example, the first mixture at a high temperature obtained from the first calcination is immediately transferred into water. For reference, the transfer should be completed within 30 min. Since the first mixture after the first calcination is at a high temperature, and the water is at a temperature of 0°C to 100°C, when the first mixture is transferred into the water within the above-mentioned time, the first mixture can be effectively crushed due to the thermal expansion and contraction effect combined with stirring. The first crushing performed in this way features relatively mild crushing conditions, which improves roundness of the crushed materials, and reduces or avoids the occurrence of sharp corners. In addition, the first crushing in this way is also conducive to removing lithium hydroxide remaining on the surface of the first mixture after the first calcination. Moreover, through the first crushing, the material can be more fully crushed, which enhances element dispersion, shortens the time required for the second calcination, and thereby further reduces the Li/Ni cation mixing.

In some optional embodiments, the water used for the first crushing has a temperature greater than 0°C and no more than 50°C, and it may be such as 5°C, 10°C, 15°C, 20°C, 25°C, 30°C, 35°C, 40°C, 45°C, or 50°C, or any other value within the range of greater than 0°C and no more than 50°C.

The first crushing is performed under stirring. As an example, a stirring speed may be 100 rpm to 200 rpm, such as 100 rpm, 120 rpm, 140 rpm, 160 rpm, 180 rpm, or 200 rpm, or any other value within the range of 100 rpm to 200 rpm. The stirring may last for 5 min to 20 min, such as 5 min, 10 min, 15 min, or 20 min, or may be any other value within the range of 5 min to 20 min.

In some optional embodiments, the second crushing may be performed by airflow crushing. In some other embodiments, the second crushing may also be performed in other ways.

In some optional embodiments, a ratio of a total mole number of lithium element in the first lithium source and the second lithium source to a total mole number of a transition metal element in the second mixture may range from 1.05: 1 to 1.1: 1, such as 1.05: 1, 1.06: 1, 1.07: 1, 1.08: 1, 1.09: 1, or 1.1: 1, or any other value within the range of 1.05: 1 to 1.1: 1.

The single-crystal ternary cathode material needs to be prepared from an excessive lithium source. In the present disclosure, the lithium source is added by addition of lithium twice, wherein the ratio of the total mole number of lithium element in the first lithium source and the second lithium source to the total mole number of the transition metal element in the second mixture may be controlled at 1.05: 1 to 1.1: 1. This avoids much residual lithium hydroxide caused by excessive total amount of the lithium source. The residual lithium hydroxide, on the one hand, needs to be washed away with an additional washing reagent, and on the other hand, is an alkaline substance, and will adversely affects the performance of the material. The amount of the first lithium source used for the first lithium addition is small. The first calcination can achieve crystal boundary fusion, so that particles are fused together. If the amount of the first lithium source is too much, it tends to cause lithium extraction from some crystal lattices during the first crushing, and it is very difficult to fill lithium vacancies resulted by lithium extraction with the second lithium source during the second lithium addition. In addition, adding lithium twice ensures a more thorough reaction between materials. After the first lithium source first reacts with the precursor, the first crushing is performed, which is not only conducive to increasing a contact area between the second mixture and the second lithium source, but also conducive to more uniform lithium distribution in the third mixture.

The second calcination may be performed at a temperature of 800°C to 950°C, such as 800°C, 820°C, 850°C, 880°C, 900°C, 920°C, or 950°C, or any other value within the range of 800°C to 950°C.

The second calcination may be performed for 4 h to 6 h, such as 4 h, 4.5 h, 5 h, 5.5 h, or 6 h, or any other value within the range of 4 h to 6 h.

The second calcination may be performed additionally in an oxygen-containing atmosphere. As an example, oxygen content in the oxygen-containing atmosphere may be $\geq$20wt%. For example, the oxygen content in the oxygen-containing atmosphere may be 20wt%, 30wt%, 40wt%, 50wt%, 60wt%, 70wt%, 80wt%, 90wt%, or 100wt%. In some optional embodiments, the oxygen content in the oxygen-containing atmosphere is $\geq$80wt%.

During the preparation of the single-crystal ternary cathode material, when the single-crystal ternary cathode material contains the doping element, in some optional embodiments, the precursor of the single-crystal ternary cathode material and the first lithium source may be mixed with the doping reagent for providing the doping element and then the first calcination is performed. In some other optional embodiments, the second mixture and the second lithium source may be mixed with the doping reagent for providing the doping element and then the second calcination is performed.

During the preparation of the single-crystal ternary cathode material, when the single-crystal ternary cathode material contains a coating element, the preparation method further includes step (5): mixing the fourth mixture with a coating reagent for providing the coating element and then performing a third calcination.

In some optional embodiments, the third calcination may be performed at a temperature of 500°C to 700°C, such as 500°C, 550°C, 600°C, 650°C, or 700°C, or any other value within the range of 500°C to 700°C.

The third calcination may be performed for 4 h to 6 h, such as 4 h, 4.5 h, 5 h, 5.5 h, or 6 h, or any other value within the range of 4 h to 6 h.

The third calcination may be performed additionally in an oxygen-containing atmosphere. As an example, oxygen content in the oxygen-containing atmosphere may be ≥20wt%. For example, the oxygen content in the oxygen-containing atmosphere may be 20wt%, 30wt%, 40wt%, 50wt%, 60wt%, 70wt%, 80wt%, 90wt%, or 100wt%. In some optional embodiments, the oxygen content in the oxygen-containing atmosphere is ≥80wt%.

In addition, the present disclosure further provides a cathode electrode sheet, wherein an active material of the cathode electrode sheet includes the single-crystal ternary cathode material according to any of the above embodiments.

In some optional embodiments, the cathode electrode sheet has an initial discharge specific capacity at 0.1C of no less than 171.0 mAh/g, and for example, it may be 171.6 mAh/g to 203.4 mAh/g, such as 171.6 mAh/g, 181.7 mAh/g, 183.5 mAh/g, 187.2 mAh/g, 187.5 mAh/g, 188.5 mAh/g, 190.3 mAh/g, 190.9 mAh /g, 193.4 mAh/g, 193.7 mAh/g, 198.8 mAh/g, 201.7 mAh/g, 202.2 mAh/g, or 203.4 mAh/g.

In some optional embodiments, the cathode electrode sheet has a capacity retention ratio at 0.1C after 50 cycles of no less than 89.2%, and for example, it may be 89.2% to 99.4%, such as 89.2%, 91.7%, 92.2%, 92.5%, 93.8%, 94.3%, 94.6%, 95.2%, 95.4%, 95.9%, 97.4%, 97.7%, 98.0%, or 99.4%.

In some optional embodiments, the cathode electrode sheet has an initial discharge specific capacity at 1C of no less than 148.3 mAh/g, and for example, it may be 148.3 mAh/g to 173.9 mAh/g, such as 148.3 mAh/g. g, 158.8 mAh/g, 159.3 mAh/g, 159.8 mAh/g, 165.1 mAh/g, 165.3 mAh/g, 168.9 mAh/g, or 173.9 mAh/g.

In some optional embodiments, the cathode electrode sheet has an initial discharge specific capacity at 5C of no less than 125.8 mAh/g, and for example, may be 125.8 mAh/g-152.2 mAh/g, such as 125.8 mAh/g. g, 136.9 mAh/g, 139.5 mAh/g, 140.0 mAh/g, 144.5 mAh/g, 145.8 mAh/g, 148.9 mAh/g, or 152.2 mAh/g.

The present disclosure further provides a battery cell, including the above cathode electrode sheet.

As an example, the battery cell may be used in, but not limited to, an electrical device, such as a vehicle, a ship, or an aircraft.

The present disclosure further provides a battery including the above battery cell.

The present disclosure further provides an electrical device, including the above battery cell and/or battery. For example, the electrical device may be, but is not limited to, a mobile phone, a tablet computer, a notebook computer, an electric toy, an electric tool, an electric bicycle, an electric vehicle, a ship, a spacecraft, and the like. The electric toy may include a stationary or mobile electric toy, such as a gaming console, an electric car toy, an electric ship toy, or an electric airplane toy, and the spacecraft may include, e.g., an airplane, a rocket, an aerospace plane, and a spaceship.

The features and performance of the present disclosure are further detailed below with reference to the examples.

Example 1

This example provided a single-crystal ternary cathode material, in which the preparation process included the following steps.

Step (1): A precursor of the single-crystal ternary cathode material was mixed with a first lithium source, then fully grinded, and performed a first calcination to obtain a first mixture.

The precursor of the single-crystal ternary cathode material was a precursor of a nickel-cobalt-manganese hydroxide $Ni_{0.5}Co_{0.2}Mn_{0.3}(OH)_2$. The first lithium source was lithium hydroxide. A ratio of a total mole number of Ni, Co, and Mn in the precursor of the nickel-cobalt-manganese hydroxide to a mole number of Li in the first lithium source was 1: 0.55. The first calcination was performed at 700°C in an oxygen-rich atmosphere (oxygen content: 98wt%) for 2 h.

Step (2): Before a temperature of the first mixture was below 600°C, the first mixture was transferred into water at a temperature of 30°C, successively performed a first crushing, filtering, and drying to obtain a second mixture.

The first crushing was performed under stirring at 150 rpm for 10 min, and the drying was performed at 100°C for 12 h.

Step (3): The second mixture was mixed with a second lithium source, and then performed a second calcination to obtain a third mixture.

The second lithium source was lithium hydroxide. A ratio of a total mole number of Ni, Co, and Mn in the second mixture to a mole number of Li in the second lithium source was 1: 0.53, i.e., a ratio of a total mole number of lithium element in the first lithium source and the second lithium source to a total mole number of a transition metal element in the second mixture was 1.08: 1. The second calcination was performed at 900°C in an oxygen-rich atmosphere (oxygen content: 98wt%) for 5 h.

Step (4): The third mixture was subjected to a second crushing by airflow crushing to obtain a fourth mixture (single-crystal ternary cathode material).

Example 2

This example was different from Example 1 in that: the ratio of the total mole number of Ni, Co, and Mn in the precursor of the nickel-cobalt-manganese hydroxide to the mole number of Li in the first lithium source was 1: 0.4.

Example 3

This example was different from Example 1 in that: the ratio of the total mole number of Ni, Co, and Mn in the precursor of the nickel-cobalt-manganese hydroxide to the mole number of Li in the first lithium source was 1: 0.7.

Example 4

This example was different from Example 1 in that: in the step (2), the stirring lasted for 5 min.

Example 5

This example was different from Example 1 in that: in the step (2), the stirring lasted for 20 min.

Example 6

This example provided a single-crystal ternary cathode material, in which the preparation process included the following steps.

Step (1): A precursor of the single-crystal ternary cathode material was mixed with a first lithium source, then fully grinded, and performed a first calcination to obtain a first mixture.

The precursor of the single-crystal ternary cathode material was a precursor of a nickel-cobalt-aluminum hydroxide $Ni_{0.821}C_{00.154}Al_{0.025}(OH)_2$. The first lithium source was lithium hydroxide. A ratio of a total mole number of Ni, Co, and Al in the precursor of the nickel-cobalt-aluminum hydroxide to a mole number of Li in the first lithium source was 1: 0.5. The first calcination was performed at 700°C in an oxygen-rich atmosphere (oxygen content: 98wt%) for 1 h.

Step (2): same as the step (2) in Example 1.

Step (3): The second mixture was mixed with a second lithium source and then performed a second calcination to obtain a third mixture.

The second lithium source was lithium hydroxide. A ratio of a total mole number of Ni, Co, and Al in the second mixture to a mole number of Li in the second lithium source was 1: 0.55, i.e., a ratio of a total mole number of lithium element in the first lithium source and the second lithium source to a total mole number of a transition metal element in the second mixture was 1.05: 1. The second calcination was performed at 800°C in an oxygen-rich atmosphere (oxygen content: 98wt%) for 6 h.

Step (4): same as the step (4) in Example 1.

Example 7

This example provided a single-crystal ternary cathode material, in which the preparation process included the following steps.

Step (1): A precursor of the single-crystal ternary cathode material was mixed with a first lithium source, then fully grinded, and performed a first calcination to obtain a first mixture.

The precursor of the single-crystal ternary cathode material was a precursor of a nickel-cobalt-manganese hydroxide $Ni_{0.8}Co_{0.1}Mn_{0.1}(OH)_2$. In this precursor, a molar ratio of Ni, Co, and Mn was 8: 1: 1. The first lithium source was lithium hydroxide. A ratio of a total mole number of Ni, Co, and Mn in the precursor of the nickel-cobalt-manganese hydroxide to a mole number of Li in the first lithium source was 1: 0.7. The first calcination was performed at 650°C in an oxygen-containing atmosphere (oxygen content: 80wt%) for 3 h.

Step (2): Before a temperature of the first mixture was lower than 550°C, the first mixture was transferred into water at a temperature of 5°C, successively performed a first crushing, filtering, and drying to obtain a second mixture.

The first crushing was performed under stirring at 100 rpm for 15 min, and the drying was performed at 100°C for 12 h.

Step (3): The second mixture was mixed with a second lithium source and zirconium oxide, then fully grinded, and performed a second calcination to obtain a third mixture.

The second lithium source was lithium hydroxide. A ratio of a total mole number of Ni, Co, and Mn in the second mixture to a mole number of Li in the second lithium source was 1: 0.4, i.e., a ratio of a total mole number of lithium element in the first lithium source and the second lithium source to a total mole number of a transition metal element in the second mixture was 1.1: 1. An amount of zirconium oxide was 1,000 ppm based on a mass of the precursor of the nickel-cobalt-manganese hydroxide. The second calcination was performed at 950°C in an oxygen-rich atmosphere (oxygen content: 98wt%) for 4 h.

Step (4): The third mixture was subjected to a second crushing by airflow crushing to obtain a fourth mixture (single-crystal ternary cathode material).

Example 8

This example provided a single-crystal ternary cathode material, in which the preparation process included the following steps.

Step (1): A precursor of the single-crystal ternary cathode material was mixed with a first lithium source, then fully grinded, and performed a first calcination to obtain a first mixture.

The precursor of the single-crystal ternary cathode material was a precursor of a nickel-cobalt-manganese hydroxide $Ni_{0.34}Co_{0.33}Mn_{0.33}(OH)_2$. In this precursor, a molar ratio of Ni, Co, and Mn was 1: 1: 1. The first lithium source was lithium hydroxide. A ratio of a total mole number of Ni, Co, and Mn in the precursor of the nickel-cobalt-manganese hydroxide to a mole number of Li in the first lithium source was 1: 0.6. The first calcination was performed at 750°C in an oxygen-containing atmosphere (oxygen content: 20wt%) for 2 h.

Step (2): Before a temperature of the first mixture was lower than 650°C, the first mixture was transferred into water at a temperature of 50°C, successively performed a first crushing, filtering, and drying to obtain a second mixture.

The first crushing was performed under stirring at 200 rpm for 15 min, and the drying was performed at 100°C for 12 h.

Step (3): The second mixture was mixed with a second lithium source and aluminum oxide, then fully grinded, and performed a second calcination to obtain a third mixture.

The second lithium source was lithium hydroxide. A ratio of a total mole number of Ni, Co, and Mn in the second mixture to a mole number of Li in the second lithium source was 1: 0.45, i.e., a ratio of a total mole number of lithium element in the first lithium source and the second lithium source to a total mole number of a transition metal element in the second mixture was 1.05: 1. An amount of aluminum oxide was 1,000 ppm based on a mass of the precursor of the nickel-cobalt-manganese hydroxide. The second calcination was performed at 900°C in an oxygen-rich atmosphere (oxygen content: 98wt%) for 5 h.

Step (4): The third mixture was subjected to a second crushing by airflow crushing to obtain a fourth mixture (single-crystal ternary cathode material).

Example 9

This example was different from Example 1 in that this example further included step (5): the fourth mixture was mixed with aluminum oxide, fully grinded, and then performed a third calcination.

An amount of aluminum oxide was 1wt% of a mass of the fourth mixture. The third calcination was performed at 500°C in an oxygen-rich atmosphere (oxygen content: 98wt%) for 4 h.

Example 10

This example was different from Example 2 in that this example further included step (5): the fourth mixture was mixed with aluminum oxide, fully grinded, and then performed a third calcination.

An amount of aluminum oxide was 1wt% of a mass of the fourth mixture. The third calcination was performed at 500°C in an oxygen-rich atmosphere (oxygen content: 98wt%) for 4 h.

Example 11

This example was different from Example 4 in that this example further included step (5): the fourth mixture was mixed with aluminum oxide, fully grinded, and then performed a third calcination.

An amount of aluminum oxide was 1wt% of a mass of the fourth mixture. The third calcination was performed at 700°C in an oxygen-rich atmosphere (oxygen content: 98wt%) for 4 h.

Example 12

This example was different from Example 5 in that this example further included step (5): the fourth mixture was mixed with aluminum oxide, fully grinded, and then performed a third calcination.

An amount of aluminum oxide was 1wt% of a mass of the fourth mixture. The third calcination was performed at 700°C in an oxygen-rich atmosphere (oxygen content: 98wt%) for 4 h.

Example 13

This example was different from Example 6 in that this example further included step (5): the fourth mixture was mixed with $H_3BO_3$, fully grinded, and then performed a third calcination.

An amount of $H_3BO_3$ was 1wt% of a mass of the fourth mixture. The third calcination was performed at 600°C in an oxygen-rich atmosphere (oxygen content: 98wt%) for 6 h.

Example 14

This example was different from Example 7 in that this example further included step (5): the fourth mixture was mixed with aluminum oxide, fully grinded, and then performed a third calcination.

An amount of aluminum oxide was 1wt% of a mass of the fourth mixture. The third calcination was performed at 700°C in an oxygen-rich atmosphere (oxygen content: 98wt%) for 4 h.

Comparative Example 1

This comparative example was different from Example 1 in that: the precursor of the nickel-cobalt-manganese hydroxide was directly mixed with the lithium source (lithium hydroxide) through. Then, a resulting mixture was fully ground, then calcined, and then airflow crushed.

The precursor of the nickel-cobalt-manganese hydroxide was same as the precursor used in Example 1. A ratio of a total mole number of Ni, Co, and Mn in the precursor of the nickel-cobalt-manganese hydroxide to a mole number of Li in the lithium source was 1: 1.08. The calcination was performed at 900°C in an oxygen-rich atmosphere (oxygen content: 98wt%) for 12 h.

Comparative Example 2

This comparative example was different from Example 1 in that: no step 2) was included, i.e., the first mixture obtained from the step (1) of Example 1 was directly mixed with the second lithium source, then the second calcination was performed, and then the step (4) in Example 1 was performed.

Comparative Example 3

This comparative example was different from Comparative Example 1 in that this comparative example further included mixing an airflow crushed material with aluminum oxide, fully grinding, and then calcining at 500°C in an oxygen-rich atmosphere (oxygen content: 98wt%) for 4 h.

An amount of aluminum oxide was 1wt% of a mass of the airflow crushed material.

Comparative Example 4

This comparative example was different from Comparative Example 2 in that: this comparative example further included mixing an airflow crushed material with aluminum oxide, fully grinding, and then calcining at 500°C in an oxygen-rich atmosphere (oxygen content: 98wt%) for 4 h.

An amount of aluminum oxide was 1wt% of a mass of the airflow crushed material.

Comparative Example 5

This comparative example was different from Example 1 in that: the first crushing was performed by dry grinding after cooling the first mixture to room temperature.

Test examples

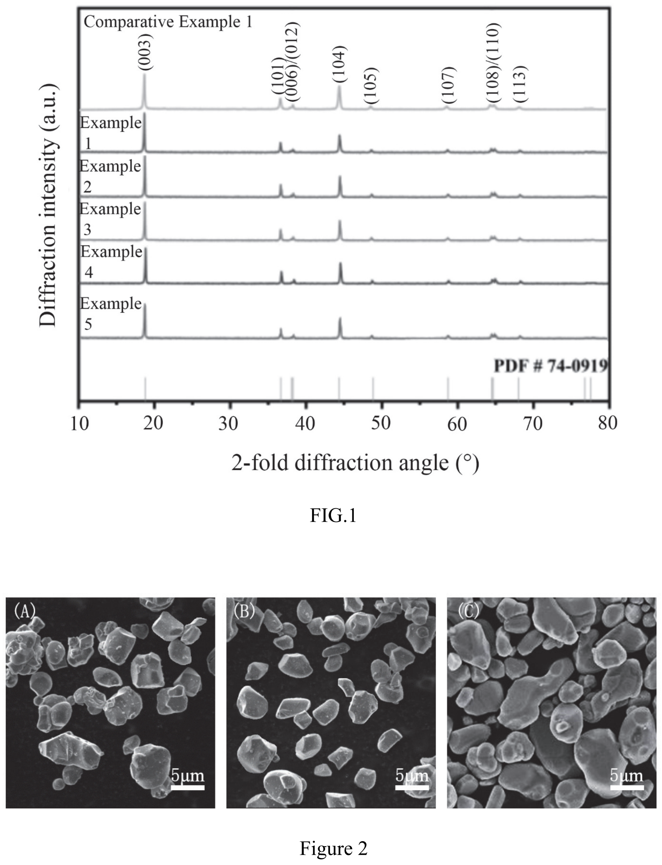

(1) Taking the single-crystal ternary cathode material obtained in each of Examples 1-5 and Comparative Example 1 as an example, the resulting single-crystal ternary cathode material was characterized by X-ray diffraction, and the resulting XRD patterns were shown in FIG. 1.

As can be seen from FIG. 1: diffraction peaks of the XRD patterns of all single-crystal materials completely correspond to the $LiNiO_2$ standard card (PDF #74-0919), indicating that all synthetic materials have hexagonal $\alpha$-$NaFeO_2$ layer structures (R-3m space groups) without additional impurity phases. In addition, as can be seen from FIG. 1, the two groups of peaks (006)/(102) and (108)/(110) are obviously divided, indicating that all synthetic materials have good crystallinity and highly ordered layer structures.

Further, the XRD pattern was fitted using MDI.Jade.6.0, to calculate lattice parameters respectively, and the results were shown in Table 1.

Table 1 Lattice parameter results

| Sample | c/a | $R=I_{(003)/(104)}$ |
|---|---|---|
| Example 1 | 4.9487 | 1.87 |
| Example 2 | 4.9375 | 1.62 |
| Example 3 | 4.9425 | 1.74 |
| Example 4 | 4.9234 | 1.51 |
| Example 5 | 4.9174 | 1.68 |
| Comparative Example 1 | 4.9207 | 1.46 |

As can be seen from Table 1, the single-crystal material prepared in each of the examples has the c/a greater than 4.899, indicating that each of the materials has a good layered structure. In addition, the R value corresponding to the material in each of Examples 1-5 is higher than that of the material in Comparative Example 1, indicating that the degree of Li/Ni cation mixing in the material obtained in each of Examples 1-5 is lower than the degree of Li/Ni cation mixing in the material obtained in Comparative Example 1.

(2) Taking the single-crystal ternary cathode material obtained in each of Example 1, Example 10, and Comparative Example 1 as an example, each single-crystal ternary cathode material was observed under a SEM, and the resulting SEM images were shown in FIG. 2. FIG. 2(A) represents a SEM image of the single-crystal ternary cathode material obtained in Example 1, FIG. 2(B) represents a SEM image of the single-crystal ternary cathode material obtained in Example 10, and FIG. 2(C) represents a SEM image of the single-crystal ternary cathode material obtained in Comparative Example 1.

As can be seen from FIG. 2, compared to the single-crystal ternary cathode material obtained in Comparative Example 1, the single-crystal ternary cathode material obtained in each of Examples 1 and 10 has better circularity and smoother corners. Moreover, the single-crystal ternary cathode material obtained in Example 10 has better circularity than that obtained in Example 1.

(3) Performance test.

①. The uncoated single-crystal ternary cathode material prepared in each of Examples 1-8 and Comparative Examples 1-2 and 5 was tested for apparent physical quantities, and then prepared into an electrode, which was tested for surface roughness, and the results were shown in Table 2.

The test method was described as follows.

A. The sample was observed using a SEM (JEOL JSM-6490LV) for its microstructure, to acquire an SEM image. The test sample was prepared by: sticking a conductive adhesive for the SEM testing to a sample platform, picking up powder of the test sample using a toothpick, gently spattering the powder on the conductive adhesive by mildly shaking the arm, then blowing off loosely adhered powder with a rubber bulb, and repeating the above operations until a layer of powder was spread on the surface of the conductive adhesive.

Then, the shape of an individual particle in the SEM image was analyzed using ImageJ, to collect parameters such as the particle number, area, circumference, and circularity. 50 samples were randomly selected and measured for each single-crystal material.

B. The single-crystal ternary cathode material was analyzed using a laser particle size analyzer (LS13320) for the particle size and particle size distribution. Specifically, the sample was uniformly dispersed by mechanical stirring using wet dispersion technology, agglomerated particles were fully dispersed by high-frequency ultrasonic oscillation, and large and small particles were uniformly distributed throughout the circulation system using an electromagnetic circulation pump.

C. The electrode was measured using a surface roughness meter (SJ-210) for the surface roughness Ra. Each electrode sample was measured at different positions 3 times, to finally calculate an average value.

The electrode was prepared by: weighing the single-crystal ternary cathode material, conductive carbon black, and PVDF at a mass ratio of 8: 1: 1, fully grinding them, and transferring them into a flask, adding an appropriate amount of a solvent N-methyl-2-pyrrolidone (NMP), and stirring a resulting mixture on a stirrer for 24 h to form a uniform slurry. The resulting slurry was uniformly coated onto a clean aluminum foil using a wet film applicator, with a loading amount controlled at $2.5\pm0.05$ mg/cm$^2$. The foil was then dried in a vacuum drying oven at 100°C for 24 h, until no loose material adhered to the foil.

Table 2 Test result

| Sample | $D_{10}$, $\mu$m | $D_{10}$', $\mu$m | H, % | $D_{90}$, $\mu$m | $S(D_{90})$ | Apparent factor | Ra, $\mu$m |
|---|---|---|---|---|---|---|---|
| Example 1 | 1.84 | 1.69 | 92 | 6.59 | 0.80 | 1.7659 | 1.23 |
| Example 2 | 1.81 | 1.57 | 87 | 5.92 | 0.73 | 2.1570 | 1.52 |
| Example 3 | 2.02 | 1.82 | 90 | 7.39 | 0.82 | 1.5992 | 1.20 |
| Example 4 | 1.92 | 1.77 | 92 | 6.09 | 0.68 | 2.8008 | 2.12 |
| Example 5 | 2.11 | 1.92 | 91 | 7.89 | 0.70 | 2.9571 | 1.84 |
| Example 6 | 1.96 | 1.72 | 88 | 6.82 | 0.71 | 2.5193 | 1.76 |
| Example 7 | 2.34 | 2.25 | 96 | 5.01 | 0.79 | 2.2532 | 1.62 |
| Example 8 | 2.15 | 1.74 | 81 | 8.56 | 0.87 | 1.1959 | 0.86 |
| Comparative Example 1 | 2.24 | 2.04 | 91 | 9.54 | 0.64 | 5.1319 | 2.59 |
| Comparative Example 2 | 2.34 | 2.18 | 93 | 9.48 | 0.61 | 5.8282 | 3.15 |
| Comparative Example 5 | 2.21 | 1.90 | 86 | 9.85 | 0.60 | 7.0385 | 3.56 |

As can be seen from Table 2, single-crystal materials with different apparent factors can be obtained by adjusting the preparation process conditions.

②. The uncoated single-crystal ternary cathode material prepared in each of Examples 1-8 and Comparative Examples 1-2 and 5 was tested for electrochemical performance.

The test method includes: punching the electrode obtained from the above test ①-C into a round electrode sheet with a diameter of 12 mm, then assembling a CR2032-type coin battery using a metallic lithium disk as a negative electrode, Celgard 2300 as a separator, and a 1 mol/L LiPF$_6$ solution (with a solvent being a mixture of EMC, DEC, and DMC in a volume ratio of 1: 1: 1) as an electrolytic solution, and testing the battery using a battery test system LANHE CT2001A for rate performance, and the results were shown in Table 3.

Table 3 Test result

| Sample | 0.1C | | 1C | 5C |
|---|---|---|---|---|
| | Initial discharge specific capacity, mAh/g | Capacity retention ratio after 50 cycles, % | Initial discharge specific capacity, mAh/g | Initial discharge specific capacity, mAh/g |
| Example 1 | 193.7 | 92.5 | 165.3 | 145.8 |
| Example 2 | 187.2 | 94.6 | 159.3 | 140.0 |
| Example 3 | 190.9 | 95.2 | 165.1 | 144.5 |
| Example 4 | 181.7 | 91.7 | 158.8 | 139.5 |
| Example 5 | 188.5 | 92.2 | 159.8 | 136.9 |
| Example 6 | 171.6 | 94.3 | 148.3 | 125.8 |
| Example 7 | 193.4 | 89.2 | 173.9 | 152.2 |
| Example 8 | 187.5 | 93.8 | 168.9 | 148.9 |
| Comparative Example 1 | 168.3 | 88.2 | 137.2 | 121.5 |
| Comparative Example 2 | 161.6 | 88.7 | 135.4 | 121.0 |
| Comparative Example 5 | 163.4 | 87.1 | 131.5 | 117.2 |

As can be seen from Table 3, the battery corresponding to the electrode sheet prepared from the single-crystal ternary cathode material provided in each of Examples 1-8 of the present disclosure has high specific capacity, cycling stability, and rate performance.

③. The coated single-crystal ternary cathode material prepared in each of Examples 9-13 and Comparative Examples 3-4 was tested for apparent physical quantities, and the resulting electrode was tested for surface roughness. The test method was same as that in the above test ①, and the test results were shown in Table 4.

Table 4 Test result

| Sample | H, % | $D_{90}/D_{10}$ | $S(D_{90})$ | Apparent factor | Ra, $\mu$m |
|---|---|---|---|---|---|
| Example 9 | 92 | 3.67 | 0.82 | 1.1634 | 1.17 |
| Example 10 | 89 | 3.35 | 0.77 | 1.3481 | 1.23 |
| Example 11 | 92 | 3.22 | 0.68 | 1.9834 | 1.75 |
| Example 12 | 92 | 3.88 | 0.73 | 1.7735 | 1.67 |
| Example 13 | 90 | 3.55 | 0.71 | 1.7978 | 1.61 |
| Example 14 | 96 | 2.36 | 0.84 | 1.6826 | 1.24 |
| Comparative Example 3 | 91 | 4.29 | 0.67 | 4.2708 | 1.88 |
| Comparative Example 4 | 93 | 4.14 | 0.64 | 4.9837 | 2.66 |

As can be seen from Table 4: the coated single-crystal ternary cathode material exhibits no significant difference from the uncoated related material in hardness and particle size distribution ratio ($D_{90}/D_{10}$), but its sphericity is increased to some extent, which in turn leads to a decrease in its apparent factor. Additionally, the apparent factor of the coated single-crystal ternary cathode material is also positively correlated with its electrode surface roughness.

④. The coated single-crystal ternary cathode material prepared in each of Examples 9-13 and Comparative Examples 3-4 was prepared into an electrode and tested for electrochemical performance. The test method was same as the above test ②, and the test results were shown in Table 5.

Table 5 Test result

| Sample | 0.1C | |
|---|---|---|
| | Initial discharge specific capacity, mAh/g | Capacity retention ratio after 50 cycles, % |
| Example 9 | 203.4 | 97.7 |
| Example 10 | 202.2 | 99.4 |
| Example 11 | 183.5 | 95.4 |
| Example 12 | 201.7 | 95.9 |
| Example 13 | 190.3 | 98.0 |
| Example 14 | 198.8 | 97.4 |
| Comparative Example 3 | 170.1 | 91.9 |
| Comparative Example 4 | 166.1 | 91.4 |

As can be seen from Table 5, the battery corresponding to the electrode prepared from the single-crystal ternary cathode material provided in each of Examples 9-13 of the present disclosure has high specific capacity and cycling stability.

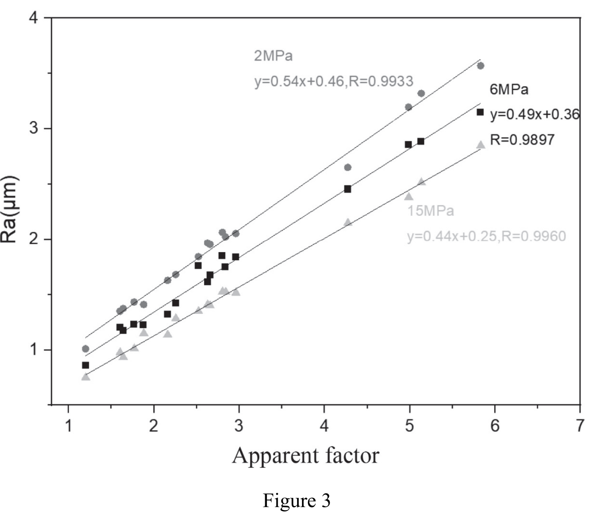

⑤. The electrode sheets from the examples and comparative examples in the test ① and test④ were placed on a hydraulic press, and calendared at a pressure of 2 MPa, 6 MPa, and 15 MPa respectively. A relationship between the apparent factor of each single-crystal ternary cathode material and the surface roughness of the electrode sheet pressed under different pressures was statistically analyzed, and the results were shown in FIG. 3. The 17 data points corresponding to each trend line in FIG. 3 represented the results in 13 examples (Examples 1-13) and 4 comparative examples (Comparative Examples 1-4). As can be seen from FIG. 3, regardless of whether the material was coated, under different calendaring pressures, the apparent factor of the single-crystal ternary cathode material is linearly positively correlated with the surface roughness of the electrode sheet.

To sum up, the present disclosure presents a single-crystal ternary cathode material with an apparent factor within a particular range. A single-crystal ternary cathode material with an apparent factor within such a range features a smooth surface and rounded corners, so that an electrode and a battery using it as a cathode material have high specific capacity, superior rate performance, and excellent cycling performance. Correspondingly, the preparation method of the single-crystal ternary cathode material is simple and easy to operate, and suitable for industrial-scale production.

Industrial applicability

The single-crystal ternary cathode material provided in the present disclosure features a smooth surface and rounded corners, and enables an electrode using it as a cathode material to have high specific capacity, superior rate performance, and excellent cycling performance. Correspondingly, the preparation method of the single-crystal ternary cathode material is simple and easy to operate, and suitable for industrial-scale production. Furthermore, the single-crystal ternary cathode material can be used to prepare batteries and electrical devices with excellent electrochemical performance.

**Claims**

1. A single-crystal ternary cathode material, having an apparent factor $Z = \dfrac{\left(\frac{1}{S(D_{90})}\right)^x \times H}{1.2 - 19.4 \times 0.18^x}$, with Z = 1.1 to 3.0;

where $x = D_{90}/D_{10}$, $2 \leq x \leq 5$; $D_{90}$ is a particle size of the single-crystal ternary cathode material when volume-based cumulative particle size distribution of the single-crystal ternary cathode material reaches 90%, $D_{10}$ is a particle size of the single-crystal ternary cathode material when the volume-based cumulative particle size distribution of the single-crystal ternary cathode material reaches 10%; $D_{10}$ of the single-crystal ternary cathode material does not exceed 2.4 $\mu$m;

$S(D_{90})$ is a number-average circularity equal to a sum of circularities of all target particles contained in the single-crystal ternary cathode material divided by n; the circularity $Q = l_2/l_1$, wherein an area and a perimeter correspond-

EP 4 730 432 A1

ing to a two-dimensional projected image of an individual target particle are defined as $S_1$ and $l_1$ respectively, a perimeter of a circle with the area Si is defined as $l_2$, the target particle is defined as a single-crystal ternary cathode material particle with a particle size greater than or equal to $D_{90}$ in the single-crystal ternary cathode material, and n is a total number of the target particles contained in the single-crystal ternary cathode material; and

H is hardness, $H = \dfrac{D_{10}{}'}{D_{10}} \times 100\%$, wherein $D_{10}'$ is a particle size when volume-based cumulative particle size distribution of a pressed material reaches 10%, the pressed material is a material obtained by pressing the single-crystal ternary cathode material under a pressure of 200 MPa; and the $D_{10}'$ of the single-crystal ternary cathode material does not exceed 2.3 $\mu$m.

2. The single-crystal ternary cathode material according to claim 1, wherein the single-crystal ternary cathode material comprises at least one of the features below:

feature I: the $D_{90}$ of the single-crystal ternary cathode material does not exceed 8.6 $\mu$m;
feature II: the H of the single-crystal ternary cathode material is not less than 80%; and
feature III: the $S(D_{90})$ of the single-crystal ternary cathode material does not exceed 0.9.

3. The single-crystal ternary cathode material according to claim 2, wherein the apparent factor of the single-crystal ternary cathode material is 1.1634 to 2.9571; and/or,

the x of the single-crystal ternary cathode material is 2.36 to 3.88; and/or,
the $D_{90}$ of the single-crystal ternary cathode material is 5.01 $\mu$m to 8.56 $\mu$m; and/or,
the $D_{10}$ of the single-crystal ternary cathode material is 1.81 $\mu$m to 2.34 $\mu$m; and/or,
the H of the single-crystal ternary cathode material is 81% to 96%; and/or,
the $S(D_{90})$ of the single-crystal ternary cathode material is 0.68 to 0.87; and/or,
the $D_{10}'$ of the single-crystal ternary cathode material is 1.57 $\mu$m to 2.25 $\mu$m.

4. The single-crystal ternary cathode material according to any one of claims 1 to 3, wherein the single-crystal ternary cathode material further comprises at least one of the features below:

feature IV: the single-crystal ternary cathode material has a particle size of no more than 20 $\mu$m;
feature V: the single-crystal ternary cathode material has a general formula of $Li_dNi_aCo_bM_cM'_{1-a-b-c}O_2$, where $0.95 \leq d < 1.1$, $a > 0$, $b > 0$, $c > 0$, $0.95 \leq (a+b+c) \leq 1$; M comprises at least one of Al and Mn, M' comprises at least one of a doping element and a coating element, and the doping element and the coating element are each independently at least one of Zr, Sr, Mo, Ba, W, B, Ti, Mg, Li, C, F, Si, Ca, Cu, La, P, Ce, Bi, In, Nb, and Y;
feature VI: in the single-crystal ternary cathode material, a unit cell parameter c and a unit cell parameter a satisfy $c/a \geq 4.899$;
feature VII: a (003) crystal plane diffraction peak intensity $I_{(003)}$ and a (104) crystal plane diffraction peak intensity $I_{(104)}$ of the single-crystal ternary cathode material satisfy: $I_{(003)}/I_{(104)} \geq 1.51$; and
feature VIII: a surface roughness Ra of an electrode sheet comprising the single-crystal ternary cathode material does not exceed 2.20 $\mu$m.

5. The single-crystal ternary cathode material according to claim 4, wherein a doping reagent providing the doping element comprises at least one of an oxide, a fluoride, a carbonate, a hydroxide, a nitride, a boride, and a nitrate comprising a corresponding doping element; and/or,
a coating reagent providing the coating element comprises at least one of an oxide, a fluoride, a carbonate, a hydroxide, a nitride, a boride, and a nitrate comprising a corresponding coating element.

6. The single-crystal ternary cathode material according to claim 4 or 5, wherein the surface roughness Ra of the electrode sheet comprising the single-crystal ternary cathode material is 0.86 $\mu$m to 2.12 $\mu$m.

7. A method for preparing the single-crystal ternary cathode material according to any one of claims 1 to 6, comprising the following step:

mixing a precursor of the single-crystal ternary cathode material with a first lithium source, and then performing a first calcination to obtain a first mixture;
immediately transferring the first mixture at a high temperature into water and performing a first crushing under stirring to obtain a second mixture;

mixing the second mixture with a second lithium source and then performing a second calcination to obtain a third mixture; and

performing a second crushing on the third mixture to obtain a fourth mixture.

8. The preparation method according to claim 7, wherein the preparation of the first mixture comprises at least one of the features below:

feature 1: the precursor of the single-crystal ternary cathode material is a hydroxide precursor;

feature 2: a ratio of a total mole number of a transition metal element in the precursor of the single-crystal ternary cathode material to a mole number of lithium element in the first lithium source ranges from 1: 0.4 to 1: 0.7;

feature 3: the first calcination is performed at a temperature of 650°C to 750°C;

feature 4: the first calcination is performed for 1 h to 3 h; and

feature 5: the first calcination is performed in an oxygen-containing atmosphere.

9. The preparation method according to claim 8, wherein the precursor of the single-crystal ternary cathode material comprises a nickel-cobalt-manganese hydroxide or a nickel-cobalt-aluminum hydroxide.

10. The preparation method according to any one of claims 7 to 9, wherein the first crushing comprises at least one of the features below:

feature 6: the first crushing is implemented based on a thermal expansion and contraction effect;

feature 7: the water used for the first crushing has a temperature greater than 0°C and no more than 50°C;

feature 8: the first crushing is performed at a stirring speed of 100 rpm to 200 rpm;

feature 9: the first crushing is performed under stirring for 5 min to 20 min; and/or,

the second crushing is performed by airflow crushing.

11. The preparation method according to any one of claims 8 to 10, wherein the first mixture at a high temperature is transferred into the water within 30 min.

12. The preparation method according to any one of claims 7 to 11, wherein the preparation of the third mixture comprises at least one of the features below:

feature 10: a ratio of a total mole number of lithium element in the first lithium source and the second lithium source to a total mole number of a transition metal element in the second mixture ranges from 1.05: 1 to 1.1: 1;

feature 11: the second calcination is performed at a temperature of 800°C to 950°C;

feature 12: the second calcination is performed for 4 h to 6 h; and

feature 13: the second calcination is performed in an oxygen-containing atmosphere.

13. The preparation method according to any one of claims 7 to 12, wherein when the single-crystal ternary cathode material contains a doping element, the precursor of the single-crystal ternary cathode material and the first lithium source are mixed with the doping reagent for providing the doping element and then the first calcination is performed; or the second mixture and the second lithium source are mixed with the doping reagent for providing the doping element and then the second calcination is performed; or,

when the single-crystal ternary cathode material contains a coating element, the preparation method further comprises: mixing the fourth mixture with the coating reagent for providing the coating element and then performing a third calcination.

14. The preparation method according to claim 13, wherein the first calcination is performed in the oxygen-containing atmosphere with an oxygen content ≥20wt%; and/or the second calcination is performed in the oxygen-containing atmosphere with an oxygen content ≥20wt%; and/or the third calcination is performed in an oxygen-containing atmosphere with an oxygen content ≥20wt%.

15. A cathode electrode sheet, wherein an active material of the cathode electrode sheet comprises the single-crystal ternary cathode material according to any one of claims 1 to 6.

16. The cathode electrode sheet according to claim 15, wherein the cathode electrode sheet has at least one of the features below:

feature IX: the cathode electrode sheet has an initial discharge specific capacity at 0.1C of no less than 171.0 mAh/g;

feature X: the cathode electrode sheet has a capacity retention ratio at 0.1C after 50 cycles of no less than 89.2%;

feature XI: the cathode electrode sheet has an initial discharge specific capacity at 1C of no less than 148.3 mAh/g; and

feature XII: the cathode electrode sheet has an initial discharge specific capacity at 5C of no less than 125.8 mAh/g.

17. A battery cell, comprising the cathode electrode sheet according to claim 15 or 16.

18. A battery, comprising the battery cell according to claim 17.

19. An electrical device, comprising the battery cell according to claim 17 and/or the battery according to claim 18.

20. The electrical device according to claim 19, wherein the electrical device comprises a mobile phone, a tablet computer, a notebook computer, an electric toy, an electric tool, an electric bicycle, an electric vehicle, a ship, or a spacecraft.

FIG.1

Figure 2

Figure 3

## INTERNATIONAL SEARCH REPORT

| International application No. |
| --- |
| **PCT/CN2024/126545** |

**A. CLASSIFICATION OF SUBJECT MATTER**

H01M4/505(2010.01)i

According to International Patent Classification (IPC) or to both national classification and IPC

**B. FIELDS SEARCHED**

Minimum documentation searched (classification system followed by classification symbols)

IPC:H01M

Documentation searched other than minimum documentation to the extent that such documents are included in the fields searched

Electronic data base consulted during the international search (name of data base and, where practicable, search terms used)

CNTXT, ENTXTC, ENTXT, DWPI, CNKI: 三元, 正极, 粒径, 粒度, 硬度, 水, 淬火, ternary, anode, particle, hardness, water, quench+

**C. DOCUMENTS CONSIDERED TO BE RELEVANT**

| Category* | Citation of document, with indication, where appropriate, of the relevant passages | Relevant to claim No. |
| --- | --- | --- |
| PX | CN 118231641 A (GUANGDONG BRUNP RECYCLING TECHNOLOGY CO., LTD. et al.) 21 June 2024 (2024-06-21) description, paragraphs 3-78 | 1-20 |
| A | WO 2022199399 A1 (BTR NANO TECHNOLOGY CO., LTD.) 29 September 2022 (2022-09-29) entire document | 1-20 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **22 November 2024** | **10 January 2025** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/126545**

| Patent document cited in search report | | | Publication date (day/month/year) | Patent family member(s) | | | Publication date (day/month/year) |
|---|---|---|---|---|---|---|---|
| CN | 118231641 | A | 21 June 2024 | CN | 118231641 | B | 18 October 2024 |
| WO | 2022199399 | A1 | 29 September 2022 | CN | 112803010 | A | 14 May 2021 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202410651224